# EUROPEAN PATENT APPLICATION

(11) **EP 4 826 955 A1**
(43) Date of publication of application: **21.10.2026**
(21) Application number: 26161059.6
(22) Date of filing: 26.02.2026
(51) Int. Cl.: H02J 7/50, H01M 10/42, H02J 7/00, H02J 7/90, H02M 3/158

(54) **REGULATED POWER SUPPLY FEATURING MODULE INTERFACE CIRCUITS FOR BATTERY MODULES**

(30) Priority: 14.04.2025 US 202519178610
(71) Applicant: The Boeing Company, Arlington, VA 22202 (US)
(72) Inventor: ATMUR, Robert J., Arlington 22202 (US); BERON-RAWDON, Deborah A., Arlington 22202 (US)
(74) Representative: Finlayson, Scott Henry

(57) **Abstract**

A regulated power supply system, an integrated system, and a method are disclosed for providing regulated electrical power to an electrical load from a battery group. In an example, the regulated power supply system includes a buck regulator operable to regulate an unregulated voltage provided at an unregulated high-side interface of the battery group to a regulated voltage at a regulated high-side interface to which an electrical load can be connected. The buck regulator is configured to command a high-side driver to pass electrical energy to an inductor via the unregulated high-side interface during an on phase of a duty cycle during which the inductor is charged. The buck regulator is further configured to discontinue passing the electrical energy to the inductor during an off phase of the duty cycle.

## Description

### FIELD

A disclosed invention relates generally to regulating electrical power supplied to an electrical load.

### BACKGROUND

Battery systems can incorporate a plurality of battery modules to provide an overall battery function and performance with respect to a load. Fixed and mobile platforms, such as aircraft, spacecraft, land-based and underwater vehicles as well power grid systems can have single to multi-module battery systems on-board for which failures can result in loss or damage to the vehicles or facilities during operation. Multi-module battery systems, including high voltage battery systems, as well as battery systems located on-board mobile platforms and fixed systems can present significant challenges with respect to determining the health and performance of individual battery modules and of the overall battery system.

Additionally, electrical loads to be powered by battery systems may be configured to operate at a particular voltage. However, batteries of a battery system typically supply an unregulated voltage that may differ from the voltage of the electrical load. Even if a stated voltage of a battery or battery system is known, the battery or battery system may exhibit diminished health and/or performance that results in an actual voltage that deviates from the stated voltage. Accordingly, the battery system may be incompatible with the electrical load.

### SUMMARY

A regulated power supply system is disclosed. In an example, the regulated power supply system comprises a battery group and a power regulation system. The battery group includes a plurality of battery modules that collectively provide an unregulated voltage, via a battery circuit, to an unregulated high-side interface relative to a ground reference.

The power regulation system includes a regulated high-side interface configured to provide a regulated voltage to an electrical load relative to the ground reference. The power regulation system further includes a plurality of module interface circuits. For each battery module of the battery group, a corresponding module interface circuit of the plurality of module interface circuits includes: a measurement circuit operable to measure a module-specific voltage of the battery module, and a switching circuit operable to switch the battery module between a connected state with respect to the battery circuit and a disconnected state with respect to the battery circuit.

The power regulation system further includes an inductor electrically coupled between the regulated high-side interface and the unregulated high-side interface, and a capacitor electrically coupled between the regulated high-side interface and an anode electrical interconnect of a module interface circuit of the plurality of module interface circuits that interconnects an anode terminal of a battery module of the plurality of battery modules to the battery circuit.

The power regulation system further includes a buck regulator configured to command a high-side driver to pass electrical energy to the inductor via the unregulated high-side interface during an on phase of a duty cycle during which the inductor is charged, and discontinue passing the electrical energy to the inductor during an off phase of the duty cycle to obtain a target voltage at the regulated high-side interface.

A method of providing regulated electrical power to an electrical load from a battery group that includes a plurality of battery modules is also disclosed. In an example, the method comprises: measuring a module-specific voltage of each battery module of the battery group; obtaining a target voltage for a regulated-high side interface connected to the electrical load; selecting a set of battery modules of the battery group for connection to an unregulated high-side interface via a battery circuit based on the target voltage and the module-specific voltage measured for each battery module of the battery group; configuring the set of battery modules in a connected state with respect to the unregulated high-side interface via the battery circuit, and other battery modules of the battery group not in the set of battery modules in a disconnected state with respect to the unregulated high-side interface via the battery circuit; and regulating an unregulated voltage provided by the set of battery modules to the unregulated high-side interface to the target voltage at the regulated high-side interface via a buck regulator.

An integrated system for providing regulated electrical power to an electrical load from a battery group that includes a plurality of battery modules is also disclosed. In an example, the integrated system comprises: the electrical load; and a power regulation system. The power regulation system includes: a regulated high-side interface configured to provide a regulated voltage to the electrical load relative to a ground reference; a plurality of module interface circuits in which, for each battery module of the battery group, a corresponding module interface circuit of the plurality of module interface circuits includes: a measurement circuit operable to measure a module-specific voltage of the battery module, and a switching circuit operable to switch the battery module between a connected state with respect to the battery circuit and a disconnected state with respect to the battery circuit. The integrated system further includes an inductor electrically coupled between the regulated high-side interface and the unregulated high-side interface; a capacitor electrically coupled between the regulated high-side interface and an anode electrical interconnect of a module interface circuit of the plurality of module interface circuits that interconnects an anode terminal of a battery module of the plurality of battery modules to the battery circuit; and a buck regulator configured to command a high-side driver to pass electrical energy to the inductor via the unregulated high-side interface during an on phase of a duty cycle during which the inductor is charged, and discontinue passing the electrical energy to the inductor during an off phase of the duty cycle to obtain a target voltage at the regulated high-side interface.

### BRIEF DESCRIPTION OF THE DRAWINGS

FIG. 1 is a schematic diagram depicting an example electrical system that includes a regulated power supply system and an electrical load.
FIG. 2 is a schematic diagram depicting additional aspects of module interface circuits of the FIG. 1.
FIG. 3 is a schematic diagram depicting an example of a module interface circuit that can take the form of or form part of the module interface circuit of FIG. 2
FIG. 4 is a flow diagram depicting an example method that can be performed by a power regulation system of FIG. 1 to provide regulated electrical power to the electrical load.
FIG. 5 is a schematic diagram depicting an example computing system.
FIG. 6 is a schematic diagram depicting an integrated system for providing regulated electrical power to an electrical load.
FIG. 7 is a flow diagram depicting an example method for performing a test process that includes measuring operating conditions of individual battery modules of a battery group.

### DETAILED DESCRIPTION

As briefly introduced above, significant challenges exist with respect to determining the status of individual battery modules and the overall battery system, particularly within the context of mobile and fixed platforms and/or high voltage installations that incorporate a multi-module battery system. In this context, "status" can refer to operating conditions indicative of health and performance of the individual battery modules and the overall battery system. One challenge associated with determining the status of individual battery modules can be due to high voltages associated with the battery modules while connected within the battery system. For example, high voltage installations can present safety and/or logistical risks to testing. This challenge can be exacerbated within the context of mobile and fixed platforms for which disassembly of the battery system or disconnection of battery modules from the battery system or load is not feasible.

Additionally, electrical loads to be powered by battery systems may be configured to operate at a particular voltage. However, batteries of a battery system typically supply an unregulated voltage that may differ from the voltage of the electrical load. Even if a stated voltage of a battery or battery system is known, the battery or battery system may exhibit diminished health and/or performance that results in an actual voltage that deviates from the stated voltage. Accordingly, the battery system may be incompatible with the electrical load.

A regulated power supply system, an integrated system, and methods are disclosed for providing regulated electrical power to an electrical load from a battery group. The disclosed systems and methods offer the potential to address the above identified issues with respect to voltage regulation within the context of power supplied by batteries that may exhibit variation in health and performance.

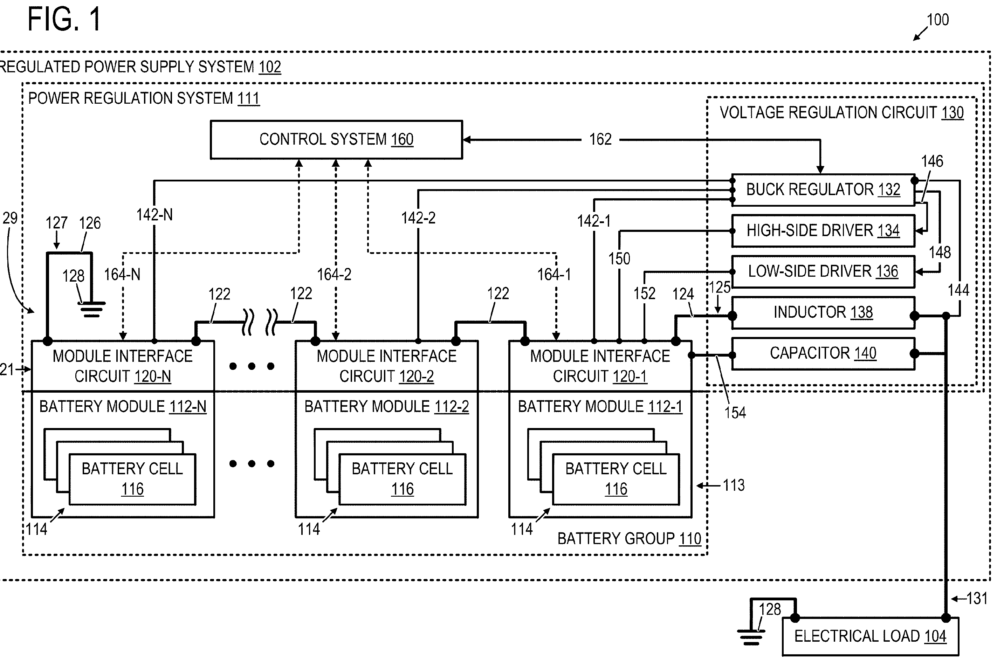

FIG. 1 is a schematic diagram depicting an example electrical system 100 that includes a regulated power supply system 102 and an electrical load 104 that is to be powered by the regulated power supply system.

Regulated power supply system 102 includes a battery group 110 of one or more battery modules that can serve as a source of unregulated electrical power for electrical load 104. In particular, battery group 110 can provide an unregulated voltage relative to a ground reference, as described in further detail herein.

Regulated power supply system 102 further includes a power regulation system 111 that can regulate the unregulated electrical power provided by battery group 110 to obtain a regulated electrical power that can be supplied to electrical load 104 by the regulated power supply system. In particular, regulated power supply system 102 can provide electrical load 104 with a regulated voltage relative to a ground reference, as described in further detail herein.

Battery system group 110 includes one or more battery modules, examples of which are depicted in FIG. 1 with reference to battery modules 112-1 through 112-N that collectively provide an unregulated electrical potential. The term "N" as used with respect to reference numeral 112-N can refer to any suitable quantity of zero or more battery modules in addition to battery module 112-1. In the example of FIG. 1, battery group 110 includes a plurality of battery modules 113, including at least a first battery module 112-1 and a second battery module 112-2. The plurality of battery modules 113 of battery group 110 can include zero, one, or more additional battery modules represented by battery module 112-N.

In some examples, the plurality of battery modules 113 of battery group 110 can be arranged in a series configuration, in a parallel configuration, or in a combination of a series and a parallel configuration with respect to electrical load 104. In the example of FIG. 1, battery modules 112-1, and 112-2 through 112-N are arranged in a series configuration.

Each battery module of battery group 110 includes a set of one or more battery cells 114, an example of which includes battery cell 116. In some examples, each battery module can include a plurality of battery cells of any suitable quantity of cells. Furthermore, in some examples, the quantity of battery cells and/or the performance of battery cells can vary between or among the battery modules of battery group 110. For example, battery module 112-1 can include a different quantity of battery cells and/or a different performance as compared to battery module 112-2. As described in further detail herein, power regulation system 111 can measure various performance parameters of each battery module of battery group 110, and can selectively connect or disconnect individual battery modules of the battery group to provide a target voltage, current, and/or power to electrical load 104.

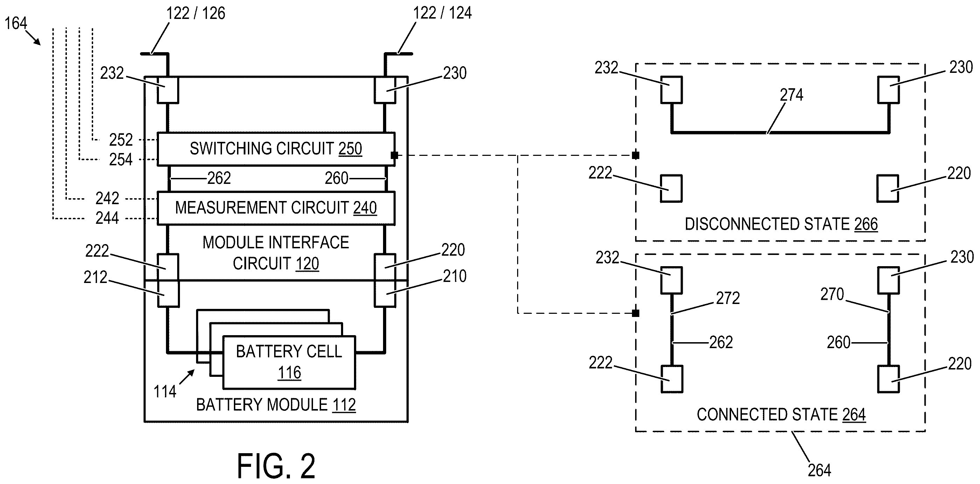

Power regulation system 111 includes a respective instance of a module interface circuit identified by reference numeral 120 for each battery module of battery group 110. For example, power regulation system 111 includes a first module interface circuit 120-1 for battery module 112-1, a second module interface circuit 120-2 for battery module 112-2, and an Nth module interface circuit 120-N for battery module 112-N. Accordingly, power regulation system 111 can include a plurality of module interface circuits 121 in a quantity that corresponds to a quantity of battery modules in examples where battery group 110 includes the plurality of battery modules 113. As described in further detail with reference to FIG. 2, each module interface circuit 120-1 through 120-N can interface with a cathode terminal and an anode terminal of a respective battery module of battery group 110.

The plurality of module interface circuits 121, including module interface circuits 120-1 through 120-N for battery group 110 can be interconnected with each other via electrical interconnects. For example, each neighboring pair of module interface circuits can be interconnected via a respective inter-module electrical interconnect 122 of power regulation system 111. In the example of FIG. 1, module interface circuit 120-1 is interconnected with module interface circuit 120-2 via an instance of inter-module electrical interconnect 122. As another example, where 120-N is a third battery module of battery group 110, module interface circuit 120-2 is interconnected with module interface circuit 120-N via another instance of inter-module electrical interconnect 122. Each instance of inter-module electrical interconnect 122 can electrically couple an anode terminal (e.g., 232 of FIG. 2) of a module interface circuit with a cathode terminal (e.g., 230 of FIG. 2) of another module interface circuit, as described in further detail with reference to FIG. 2.

Power regulation system 111 includes a high-side electrical interconnect 124 that is electrically coupled to a cathode terminal of a module interface circuit (e.g., 120-1) that serves as an unregulated high-side interface 125 of battery group 110. The term "high-side" refers to a high electrical potential relative to a ground reference 128.

Power regulation system 111 includes a low-side electrical interconnect 126 that is electrically coupled to an anode terminal of a module interface circuit (e.g., 120-N) that serves as an unregulated low-side interface 127 of battery group 110. The term "low-side" refers to a low electrical potential relative to ground reference 128.

The module interface circuits (e.g., 120-1 through 120-N) for battery group 110 together with inter-module electrical interconnects 122, high-side electrical interconnect 124, and low-side electrical interconnect 126 forms a battery circuit 129 between unregulated high-side interface 125 and unregulated low-side interface 127. As described in further detail with reference to FIG. 2, each module interface circuit includes a switching circuit that is operable to connect its battery module to and disconnect its battery module from battery circuit 129.

Power regulation system 111 further includes a voltage regulation circuit 130 that can regulate an unregulated electrical voltage provided by battery group 110 at unregulated high-side interface 125 to obtain a regulated electrical voltage at a regulated high-side interface 131 of power regulation system 111. The term "high-side" again refers to a high electrical potential relative to ground reference 128. In the example of FIG. 1, electrical load 104 is connected to regulated high-side interface 131 and to ground reference 128.

Voltage regulation circuit 130 includes a buck regulator 132, a high-side driver 134, a low-side driver 136, an inductor 138, and a capacitor 140.

Buck regulator 132 provides a buck regulator function that includes regulating unregulated voltage at unregulated high-side interface 125 relative to ground reference 128 down to a regulated voltage at regulated high-side interface 131 relative to ground reference 128 through the use of high-side driver 134 and low-side driver 136. In some examples, buck regulator 132 can take the form of an integrated circuit that provides the buck regulator function.

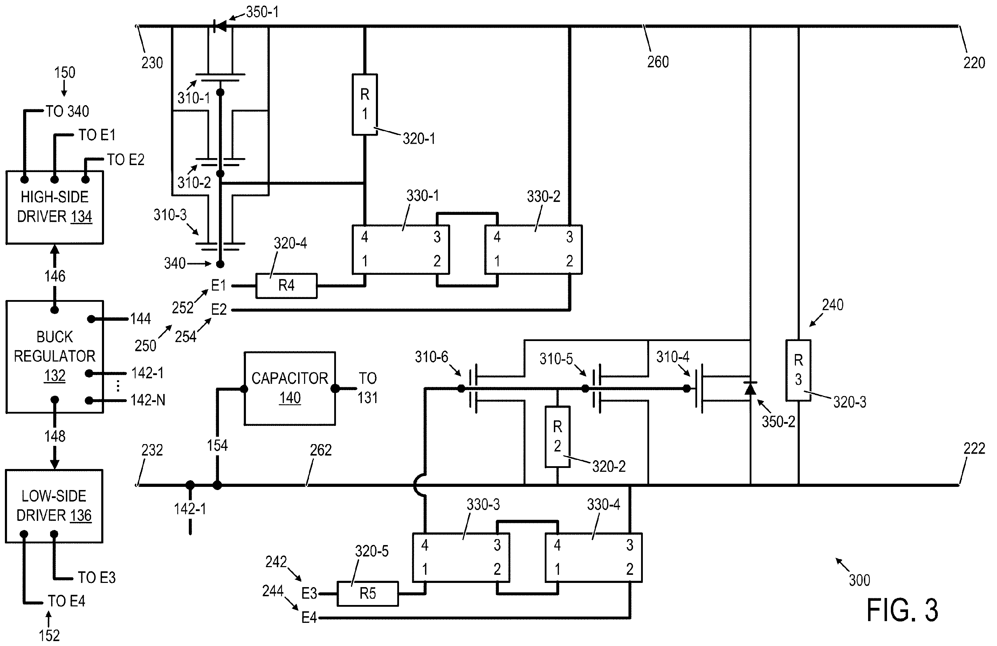

As depicted schematically in FIG. 1, buck regulator 132 is electrically coupled with various components of module interface circuit 120-1 via a set of one or more electrical connections 142-1, described in further detail with reference to FIG. 3. As an example, the set of electrical connections 142-1 can serve as a current sensing path that enables buck regulator 132 to halt the transfer of electrical energy between unregulated high-side interface 125 and regulated high-side interface 131 in scenarios where a current sensed via the current sensing path of the set of electrical connections 142-1 exceeds a threshold value. In this example, voltage regulation circuit 130 can provide over current protection by halting the transfer of electrical energy responsive to the current sensed via the set of electrical connections 142-1 exceeding the threshold value. A corresponding set of one or more electrical connections as similarly described with reference to 142-1 can be provided between each module interface circuit of the plurality module interface circuits 121 and buck regulator 132, as depicted schematically with reference to a set of one or more electrical connections 142-2 with respect to module interface circuit 120-2, and with reference to a set of one or more electrical connections 142-N with respect to module interface circuit 120-N. Accordingly, voltage regulation circuit 130 can provide over current protection with respect to individual battery modules of battery group 110 via their respective module interface circuit. Additionally, buck regulator 132 is electrically coupled with regulated high-side interface 131 via an electrical connection 144 that serves as a regulated high-side feedback path to the buck regulator for use in regulating voltage of unregulated high-side interface 125 to a target voltage at regulated high-side interface 131.

Buck regulator 132 is connected to high-side driver 134 via an electrical connection 146. Buck regulator 132 can provide a command signal to high-side driver 134 via electrical connection 146 according to a duty cycle for the high-side driver. As depicted schematically in FIG. 1, high-side driver 134 is electrically coupled with various components of module interface circuit 120-1 via a set of electrical connections 150, described in further detail with reference to FIG. 3.

Buck regulator 132 is connected to low-side driver 136 via an electrical connection 148. Buck regulator 132 can provide a command signal to low-side driver 136 via electrical connection 148 according to a duty cycle for the low-side driver. As depicted schematically in FIG. 1, low-side driver 136 is electrically coupled with various components of module interface circuit 120-1 via a set of electrical connections 152, described in further detail with reference to FIG. 3.

Inductor 138 is electrically coupled between unregulated high-side interface 125 and regulated high-side interface 131. Capacitor 140 is electrically coupled to regulated high-side interface 140. As depicted schematically in FIG. 1, capacitor 140 is electrically coupled with various components of module interface circuit 120-1 via a set of electrical connections 154, described in further detail with reference to FIG. 3.

Power regulation system 111 further includes a control system 160 that can control operation of buck regulator 132 and each module interface circuit (e.g., 120-1 through 120-N) of the plurality of module interface circuits 121. As an example, control system 160 can serve as a voltage controller with respect to voltage regulation circuit 130, including specifying, to buck regulator 132, a target value (i.e., a target voltage) of a regulated voltage at regulated high-side interface 131 that is connected to load 104. Buck regulator 132 can regulate an unregulated voltage provided to unregulated high-side interface 125 by battery group 110 via battery circuit 129 to the target value of the regulated voltage at regulated high-side interface 131. Additionally, control system 160 can serve as an over current protection controller that terminates the transfer of electrical energy between unregulated high-side interface 125 and regulated high-side interface 131 responsive to current at any of the battery modules of battery group 110 exceeding a current threshold, as measured or otherwise obtained via the module interface circuits associated with the battery modules.

In FIG. 1, control system 160 is electrically coupled to buck regulator 132 via a set of electrical connections 162 by which the control system can communicate with the buck regulator. Additionally, control system 160 is electrically coupled to each module interface circuit (e.g., 120-1 through 120-N) of the plurality of module interface circuits 121 via a respective set of electrical connections identified by reference numeral 164. For example, control system 160 is electrically coupled to module interface circuit 120-1 via a set of electrical connections 164-1 by which the control system can communicate with module interface circuit 120-1. Control system 160 is electrically coupled to module interface circuit 120-2 via a set of electrical connections 164-2 by which the control system can communicate with module interface circuit 120-2. Control system 160 is electrically coupled to module interface circuit 120-N via a set of electrical connections 164-N by which the control system can communicate with module interface circuit 120-N.

FIG. 2 is a schematic diagram depicting additional aspects of module interface circuits 120-1 through 120-N of FIG. 1, as described with reference to module interface circuit 120 electrically coupled to battery module 112. Module interface circuit 120 of FIG. 2 represents any of module interface circuits 120-1 through 120-N of FIG. 1. Similarly, battery module 112 of FIG. 2 represents any of battery modules 112-1 through 112-N of FIG. 1.

In FIG. 2, battery module 112 includes a cathode terminal 210 and an anode terminal 212. Module interface circuit 120 includes a module-side cathode interface 220 by which the module interface circuit is electrically coupled to cathode terminal 210 of battery module 112. Module interface circuit 120 further includes a module-side anode interface 222 by which the module interface circuit is electrically coupled to anode terminal 212 of battery module 112.

Module interface circuit 120 further includes a load-side cathode interface 230 by which the module interface circuit is electrically coupled to an instance of inter-module electrical interconnect 122 or high-side electrical interconnect 124 of FIG. 1, depending on the relative location of battery module 112 within battery group 110. Module interface circuit 120 further includes a load-side anode interface 232 by which the module interface circuit is electrically coupled to an instance of inter-module electrical interconnect 122 or low-side electrical interconnect 126 of FIG. 1, depending on the location of battery module 112 within battery group 110.

Module interface circuit 120 further includes a measurement circuit 240 and a switching circuit 250, examples of which are described in further detail with reference to FIG. 3. Each module interface circuit (e.g., 120-1 through 120-N) of battery group 110 of FIG. 1 similarly includes an instance of measurement circuit 240 and an instance of switching circuit 250.

Module interface circuit 120 includes a cathode electrical interconnect 260 that electrically couples module-side cathode interface 220 to load-side cathode interface 230, and an anode electrical interconnect 262 that electrically couples module-side anode interface 222 to load-side anode interface 232. Measurement circuit 240 and switching circuit 250 are located along cathode electrical interconnect 260 and anode electrical interconnect 262, as described in further detail with reference to FIG. 3.

Measurement circuit 240 is operable by control system 160 of FIG. 1 to measure one or more operating conditions of battery module 112 to obtain one or more module-specific measurements for the battery module. Operating conditions of battery module 112 can be measured by measurement circuit 240 with respect to cathode electrical interconnect 260 and anode electrical interconnect 262, for example, to obtain module-specific measurements between or across cathode terminal 210 and anode terminal 212 of battery module 112.

As an example, an operating condition measured by measuring circuit 240 includes a voltage between or across cathode terminal 210 and anode terminal 212, in which case the module-specific measurement includes a measured value of the voltage. Additionally or alternatively, an operating condition measured by measuring circuit 240 is a current between or across cathode terminal 210 and anode terminal 212, in which case the module-specific measurement includes a measured value of the current. Additionally or alternatively, an operating condition measured by measuring circuit 240 is an electrical power between or across cathode terminal 210 and anode terminal 212, in which case the module-specific measurement includes a measured value of the electrical power.

Control system 160 can control measurement circuit 240 to obtain module-specific measurements with respect to battery module 112 via one or more of electrical connections 164, examples of which are schematically depicted in FIG. 2 as electrical connections 242 and 244. Electrical connections 164 of FIG. 1 refers to any of electrical connections 164-1 through 164-N of FIG. 1. Control system 160 can receive the module-specific measurements from measurement circuit 240 via electrical connections 242 and/or 244. The module-specific measurements obtained by control system 160 with respect to battery module 112 are independent of other battery modules of battery group 110, thereby enabling control system 160 to assess the performance of each battery module of the battery group. Control system 160 can similarly control other instances of measurement circuit 240 of each module interface circuit (e.g., 120-1 through 120-N) of battery group 110 to obtain module-specific measurements of other battery modules of the battery group. As an example, for each battery module 112-1 through 112N of battery group 110, control system 160 obtains one or more module-specific measurements (e.g., of voltage, current, power, etc.) from an instance of measurement circuit 240 of the module interface circuit that interfaces with that battery module.

Switching circuit 250 of module interface circuit 120 is operable by control system 160 of FIG. 1 to connect battery module 112 to battery circuit 129 to provide a connected state of the battery module with respect to the battery circuit. Additionally, switching circuit 250 of module interface circuit 120 is operable by control system 160 of FIG. 1 to disconnect battery module 112 from battery circuit 129 to provide a disconnected state of the battery module with respect to the battery circuit. By connecting battery module 112 to battery circuit 129, the battery module can contribute to a combined voltage, current, and electrical power that is provided by battery group 110 to unregulated high-side interface 125 and unregulated low-side interface 127 of battery circuit 129. By disconnecting battery module 112 from battery circuit 129, the battery module does not contribute to the combined voltage, current, or electrical power that is provided to battery circuit 129 by battery group 110. Switching circuit 250 can connect and disconnect battery module 112 with respect to battery circuit 129 independent of other battery modules of battery group 110.

Control system 160 can control switching circuit 250 via one or more of electrical connections 164 to connect or disconnect battery module 112 from battery circuit 129 of FIG. 1. Examples of electrical connections 164 include electrical connections 252 and 254. Control system 160 can similarly control other instances of switching circuit 250 of other module interface circuits of battery group 110 of FIG. 1.

FIG. 2 schematically depicts an example electrical path configuration for a connected state 264 of battery module 112 with respect to battery circuit 129 as provided by switching circuit 250. When battery module 112 is connected to battery circuit 129 in connected state 264, switching circuit 250 establishes an electrical connection 270 via cathode electrical interconnect 260 between load-side cathode interface 230 and module-side cathode interface 220 that interfaces with cathode terminal 210 of the battery module. Accordingly, cathode terminal 210 of battery module 112 is electrically coupled to load-side cathode interface 230 in connected state 264. Additionally, when battery module 112 is connected to battery circuit 129 in connected state 264, switching circuit 250 establishes an electrical connection 272 via anode electrical interconnect 262 between load-side anode interface 232 and module-side anode interface 222 that interfaces with anode terminal 212 of the battery module. Accordingly, anode terminal 212 of battery module 112 is electrically coupled to load-side anode interface 232 in connected state 264.

FIG. 2 schematically depicts an example electrical path configuration for a disconnected state 266 of battery module 112 with respect to battery circuit 129 as provided by switching circuit 250. When battery module 112 is disconnected from battery circuit 129 in disconnected state 266, switching circuit 250 terminates previously described electrical connections 260 and 262, and establishes an electrical connection 274 via cathode electrical interconnect 260 between load-side cathode interface 230 and load-side anode interface 232. Accordingly, cathode terminal 210 of battery module 112 is no longer electrically coupled to load-side cathode interface 230 in disconnected state 266. Additionally, in at least some examples, anode terminal 212 of battery module 112 is no longer electrically coupled to load-side anode interface 232 in disconnected state 266.

FIG. 3 is a schematic diagram depicting an example of a module interface circuit 300 that can take the form of or form part of module interface circuit 120 of FIG. 2, including any of module interface circuits 120-1 through 120-N of FIG. 1. Circuit 300 includes examples of module-side cathode interface 220, module-side anode interface 222, load-side cathode interface 230, load-side anode interface 232, measurement circuit 240, and switching circuit 250 of FIG. 2. Additionally, in FIG. 3, cathode electrical interconnect 260 electrically couples module-side cathode interface 220 to load-side cathode interface 230, and an anode electrical interconnect 262 electrically couples module-side anode interface 222 to load-side anode interface 232.

In the example of FIG. 3, circuit 300 includes a set of electrical components, including six transistors 310-1, 310-2, 310-3, 310-4, 310-5, 310-6, five resistors 320-1, 320-2, 320-3, 320-4, 320-5, four optical isolators 330-1, 330-2, 330-3, 330-4, and two diodes 350-1, 350-2 interconnected via electrical connections. It will be understood that circuit 300 can take other suitable forms and can include a different quantity and configuration of electrical components from the example depicted in FIG. 3 to implement the functions of measurement circuit 240 and switching circuit 250.

Furthermore, in the example of FIG. 3, measurement circuit 240 includes resistor 320-3 across which electrical current and/or electrical voltage can be measured, as examples of module-specific operating conditions that can be measured via measurement circuit 240. In at least some examples, measurement circuit 240 can further include an electrical test load across which the module-specific operating conditions can be measured by the measurement circuit.

Within circuit 300, node E1 interfaces with electrical connection 252 of FIG. 2, node E2 interfaces with electrical connection 254 of FIG. 2, node E3 interfaces with electrical connection 242 of FIG. 2, and node E4 interfaces with electrical connection 244 of FIG. 2.

FIG. 3 further depicts buck regulator 132, high-side driver 134, low-side driver 136, and capacitor 140 within the context of circuit 300 in examples where circuit 300 refers to module interface circuit 120-1 of FIG. 1. For example, with respect to capacitor 140, electrical connection 154 of FIG. 1 is electrically coupled to anode electrical interconnect 262 or load-side anode interface 232. As another example, with respect to buck regulator 132, electrical connection 142-1 of FIG. 1 is electrically coupled to anode electrical interconnect 262 or load-side anode interface 232. In this example, electrical connection 142-1 provides current sensing to buck regulator 132.

As another example, the set of electrical connections 150 of FIG. 1 with respect to high-side driver 134 includes electrical connections to node E1, node E2, and node 340. In the context of circuit 300, node 340 refers to a gate node of one of transistors 310-1, 310-2, 310-3 or other suitable switch. In this example, high-side driver 134 controls the flow of electrical energy between nodes E1 and E2 responsive to command signals (e.g., a duty cycle signal) received from buck regulator 132 via 146. As another example, the set of electrical connections 152 of FIG. 1 with respect to low-side driver 136 includes electrical connections to node E3 and node E4. In this example, low-side driver 136 controls the flow of electrical energy between nodes E3 and E4 responsive to command signals (e.g., a duty cycle signal) received from buck regulator 132 via 148.

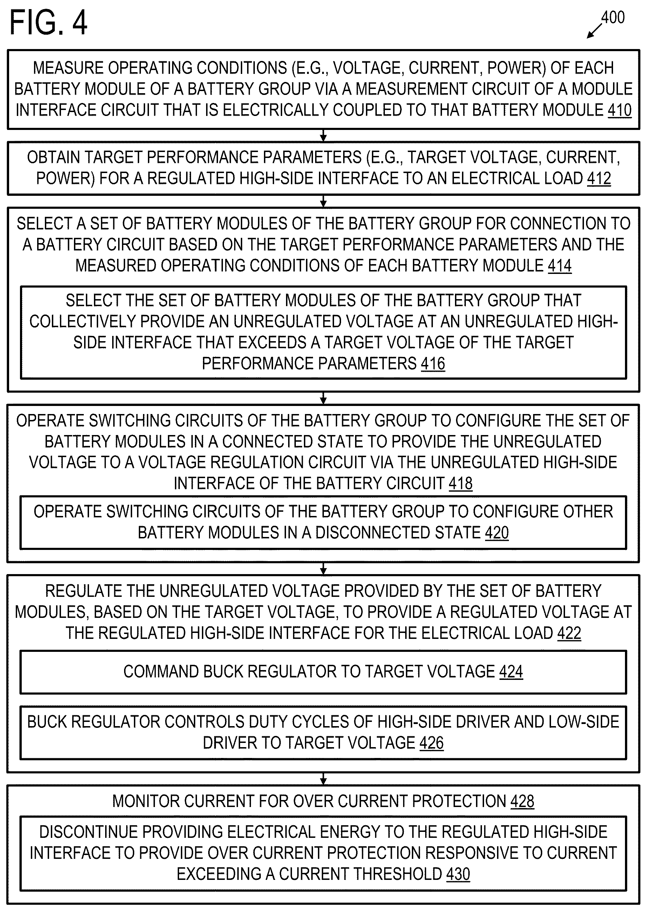

FIG. 4 is a flow diagram depicting an example method 400 that can be performed by power regulation system 111 to provide regulated electrical power to electrical load 104 from battery group 110 of FIG. 1.

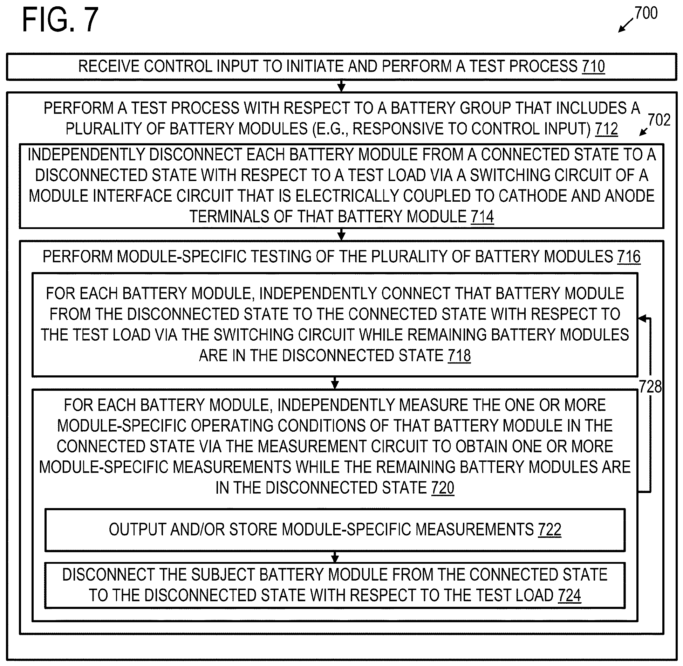

At 410, the method includes measuring one or more operating conditions (e.g., voltage, current, electrical power) of each battery module (e.g., 112-1 through 112-N) of battery group 110 via a measurement circuit (e.g., 240 of FIG. 2) of a module interface circuit that is electrically coupled to that battery module. As an example, control system 160 of FIG. 1 can operate measurement circuit 240 of each module interface circuit (e.g., 120-1 through 120-N) to obtain a measurement of voltage, a measurement of current, and a measurement of electrical power provided by each battery module of battery group 110. An example method of measuring operating conditions of battery modules as part of operation 410 is described in further detail with reference to FIG. 7.

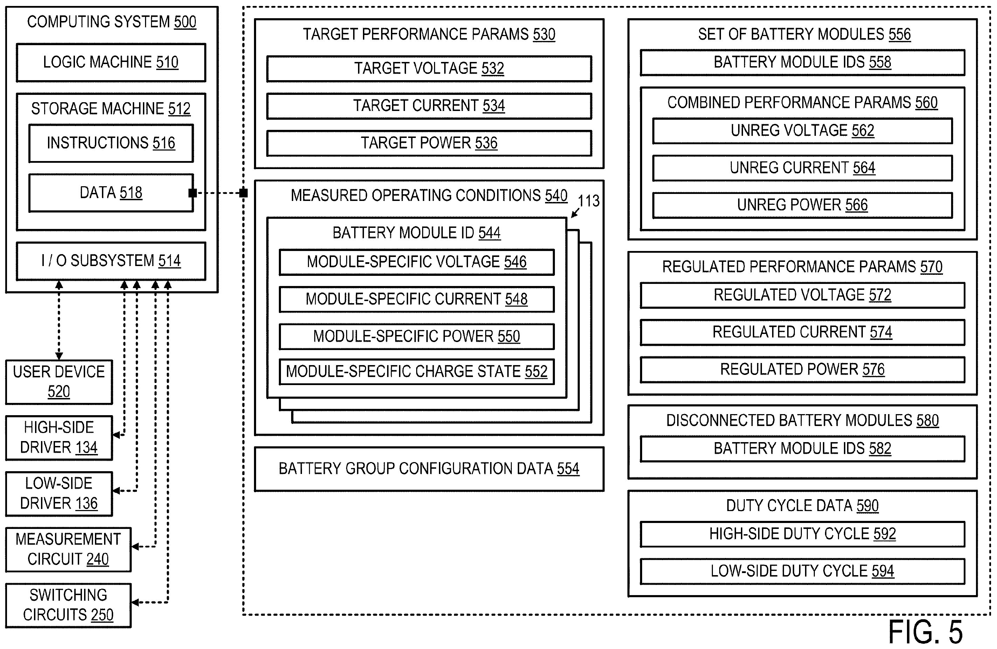

At 412, the method includes obtaining one or more target performance parameters (e.g., a target voltage, a target current, a target electrical power) for regulated high-side interface 125 relative to ground reference 128 for electrical load 104. As an example, electrical load 104 is configured to operate at the one or more target performance parameters, including at least a target voltage. In some examples, the one or more target performance parameters can further include a target current and/or a target electrical power. As described in further detail with reference to FIG. 5, control system 160 of FIG. 1 can obtain the one or more target performance parameters from a user device (e.g., as user input specifying the target performance parameters), or from a data storage device of the control system (e.g., as previously stored target performance parameters), as examples.

At 414, the method includes selecting a set of one or more battery modules of battery group 110 for connection to battery circuit 129 based on the target performance parameters obtained at 412 and the measured operating conditions of each battery module obtained at 410. Operation 414 can be performed by control system 160 of FIG. 1.

As part of operation 414, the method at 416 can include selecting the set of battery modules of battery group 110 that collectively provide an unregulated voltage at unregulated high-side interface 125 of battery circuit 129 that exceeds the target voltage of the target performance parameters. In some examples, the set of battery modules selected at operations 414 and 416 can include fewer than all battery modules of the battery group. For example, voltage measured for each battery module at 410 can be used by control system 160 to select any suitable quantity of battery modules of battery group 110 that can collectively provide an unregulated voltage via battery circuit 129 that exceeds the target voltage for electrical load 104. It will be understood that control system 160 can further select the set of battery modules at 414 based on other target performance parameters, including a target current (e.g., a target minimum current at the target voltage) and/or a target electrical power (e.g., a target minimum electrical power at the target voltage) for electrical load 104.

At 418, the method includes operating the switching circuits (e.g., 250 of FIG. 2) of battery group 110 to configure the set of battery modules selected at 414 in a connected state (e.g., 264 of FIG. 2) with respect to battery circuit 129 to provide the unregulated voltage to voltage regulation circuit 130 of FIG. 1. As previously described with reference to power regulation system 111, voltage regulation circuit interfaces with unregulated high-side interface 125 of battery circuit 129, and with regulated high-side interface 131 that interfaces with electrical load 104. In some examples, the switching circuits of the battery group can be operated at 420 to configure other battery modules in disconnected state 266 that are not part of the set of battery modules selected at 414. Operations 418 and 420 can be performed by control system 160 of FIG. 1 through interaction with respective instances of switching circuit 250 of the module interface circuits that are electrically coupled to each battery module of battery group 110.

At 422, the method includes regulating the unregulated voltage provided by the set of battery modules at unregulated high-side interface 125, based on the target voltage obtained at 412, to provide a regulated voltage at regulated high-side interface 131 for electrical load 104. As part of operation 422, the method at 424 includes commanding buck regulator 132 to the target voltage. As an example, control system 160 commands buck regulator 132 of voltage regulation circuit 130 to regulate the unregulated voltage at unregulated high-side interface 125 to obtain the target voltage for the regulated voltage at regulated high-side interface 131. Additionally, as part of operation 422, the method at 426 includes buck regulator 132 controlling the duty cycles of high-side driver 134 and low-side driver 136 to achieve the target voltage for the regulated voltage provided at the regulated high-side interface 131.

As an example, buck regulator 132 is configured to control the duty cycle of high-side driver 134 to: (1) pass electrical energy through transistors 310-1, 310-2, and 310-3 of FIG. 3 and onward to inductor 138 during an on phase of the duty cycle for a period of time during which the inductor is charged, and (2) discontinue passing electrical energy through transistors 310-1, 310-2, and 310-3 and onward to inductor 138 during an off phase of the duty cycle during which electrical energy recycles through low-side driver 136. During the off phase of the duty cycle of high-side driver 134, buck regulator 132 can control the duty cycle of low-side driver 136 to an on phase to pass electrical energy recycled from inductor 138 back to the set of battery modules that are connected to battery circuit 129. During the on phase of the duty cycle of high-side driver 134, buck regulator 132 can control the duty cycle of low-side driver 136 to an off phase to discontinue passing electrical energy back to the set of battery modules that are connected to battery circuit 129.

At 428, the method can further include monitoring current at the battery modules for over current protection. As part of operation 428, the method at 430 can include discontinuing to provide electrical energy to regulated high-side interface 131 via voltage regulation circuit 130 to provide over current protection responsive to the current exceeding a threshold current. As an example, buck regulator 132 can discontinue operating high-side driver 134 and low-side driver 136 according to their duty cycles, in which case buck regulator 132 can command high-side driver 134 to an off state in which electrical energy is not passed through transistors 310-1, 310-2, and 310-3 and onward to inductor 138. Furthermore, in at least some examples, monitoring at operation 428 can be performed by control system 160, in which case the control system can command buck regulator 132 to provide over current protection at operation 430.

In at least some examples, the methods and operations described herein, including method 400 of FIG. 4, can be performed by a computing system of one or more computing devices. FIG. 5 is a schematic diagram depicting an example computing system 500 that is configured to perform the methods and operations described herein. Computing system 500 can include or take the form of control system 160 of FIG. 1. Furthermore, in some examples, computing system 500 can include buck regulator 132 of FIG. 1.

Computing system 500 includes a logic machine 510, a storage machine 512, and an input / output (I/O) subsystem 514. Computing system 500 can include other components not shown in FIG. 5. It will be understood that computing system 500 is depicted in simplified form in FIG. 5.

Logic machine 510 includes one or more physical logic devices configured to execute instructions. For example, logic machine 510 can execute instructions 516 stored at storage machine 512. Instructions 510 can include or form part of one or more applications, services, programs, routines, libraries, objects, components, data structures, or other logical constructs. Instructions 516 can be implemented by logic machine 510 to perform a task, implement a data type, transform the state of one or more data components, achieve a technical effect, or otherwise arrive at a desired result.

Logic machine 510 can include one or more processor devices configured to execute software instructions. Additionally, or alternatively, logic machine 510 can include one or more hardware or firmware logic machines configured to execute hardware or firmware instructions. Processor devices of logic machine 510 can be single-core or multi-core, and the instructions executed thereon may be configured for sequential, parallel, and/or distributed processing. In some examples, individual components of logic machine 510 can be distributed between or among two or more separate devices, which may be remotely located and/or configured for coordinated processing. As an example, logic machine 510 can be distributed between or among control system 160 and buck regulator 132 of FIG. 1. Furthermore, in some examples, aspects of logic machine 510 can be virtualized and executed by remotely accessible, networked computing devices.

Storage machine 512 includes one or more physical storage devices configured to hold instructions 516 executable by logic machine 510 and other data 518 that can be stored, processed, and/or output by the logic machine as part of performing the methods and operations described herein. When such methods and operations are performed or otherwise implemented, the state of storage machine 512 may be transformed-e.g., to hold different data.

Storage machine 512 can include removable and/or built-in storage devices. As examples, storage machine 512 can include optical memory, semiconductor memory (e.g., RAM, EPROM, EEPROM, etc.), and/or magnetic memory, among others. Storage machine 512 can include volatile, nonvolatile, dynamic, static, read/write, read-only, random-access, sequential-access, location-addressable, file-addressable, and/or content-addressable devices.

In some examples, aspects of logic machine 510 and storage machine 512 can be integrated together into one or more hardware-logic components. Such hardware-logic components can include field-programmable gate arrays (FPGAs), program- and application-specific integrated circuits (PASIC / ASICs), program- and application-specific standard products (PSSP / ASSPs), system-on-a-chip (SOC), and complex programmable logic devices (CPLDs), for example.

Input / output (I/O) subsystem 514 can include one or more interface devices that operatively couple computing system 500 to other devices. Input / output subsystem 514 can be used by computing system 500 to send data and/or control signals to and receive data and/or control signals from other devices. Examples of devices that can interface with input / output subsystem 514 include a user device 520, high-side driver 134, low-side driver 136, instances of measurement circuit 240 of each of the module interface circuits, instances of switching circuit 250 of each of the module interface circuits, and/or other suitable devices. In cases where computing system 500 does not include buck regulator 132, the buck regulator can interface with computing system 500 via input / output subsystem 514.

As an example, computing system 500 can obtain target performance parameters (e.g., 530 of FIG. 5) from a user device 520 via input / output subsystem 514 as part of operation 412 of FIG. 4. User device 520 can take the form of a computing device or a computing system operated by a human user, as an example. As another example, computing system 500 can output a high-side driver command signal to high-side driver 134 to control the duty cycle of the high-side driver, and can output a low-side driver command signal to low-side driver 136 via input / output subsystem 514 to control the duty cycle of the low-side driver as part of regulating voltage at operation 422 of FIG. 4. As another example, computing system 500 can send command signals to instances of measurement circuit 240 and/or switching circuit 250, and can receive measurements of performance parameters (e.g., 540 of FIG. 5) from instances of the measurement circuit via input / output subsystem 514. As yet another example, computing system 500 can send commands to buck regulator 132 via input / output subsystem 514 as part of operations 422 and 428 of FIG. 4. In further examples, input / output subsystem 514 can include interface devices that operatively couple computing system 500 to communications networks (e.g., the Internet and/or a local area network).

FIG. 5 depicts further aspects of data 518, which can include data that is stored at storage machine 512, and data that is received, processed, generated, and/or output by logic machine 510 as part of performing the methods and operations described herein. Data 518 can also include data received from other devices via input / output subsystem 514.

Data 518 can include target performance parameters 530 for the regulated electrical power that is to be provided to an electrical load. As an example, target performance parameters 530 can include a target voltage 532, a target current 534, a target power 536, and/or other suitable target performance parameters.

Data 518 can include measured operating conditions 540 for each battery module of the plurality of battery modules 113 of battery group 110 of FIG. 1. As an example, measured operating conditions 540 for each battery module identified by a respective battery module identifier 544 of the plurality of battery modules 113 can include a module-specific voltage 546, a module-specific current 548, a module-specific power 550, a module-specific charge state 552, and/or other suitable measured operating conditions. Measured operating conditions 540 can be obtained for each battery module via an instance of measurement circuit 240 that is associated with that battery module, as previously described with reference to operation 410 of FIG. 4.

Data 518 can include battery group configuration data 554 that describes an electrical configuration (e.g., series and/or parallel configurations) of the plurality of battery modules 113 of battery group 110. Configuration data 554 can be used by computing system 500, in combination with measured operating conditions 540, to select a set of one or more battery modules (e.g., 556 of FIG. 5) from among the plurality of battery modules 113 of the battery group, and to determine combined performance parameters (e.g., 560) for the set of battery modules.

Data 518 can identify a set of one or more battery modules 556 selected by computing system 500, as previously described with reference to operation 414 of FIG. 4. Battery modules contained in the set of battery modules 556 can be identified by respective battery module identifiers 558. For the set of battery modules 556 identified by battery module identifiers 558 that are connected to battery circuit 129 according to a battery group configuration identified by battery group configuration data 554, data 518 can include combined performance parameters 560. Combined performance parameters 560 can include an unregulated voltage 562, an unregulated current 564, an unregulated power 566, and/or other suitable combined performance parameters that can be determined based on measured operating conditions 540 for the set of batteries. As an example, unregulated voltage 562 of combined performance parameters 560 can include the contribution of module-specific voltage 546 of each battery module of the set of battery modules 556 within the context of battery group configuration identified by configuration data 554.

Data 518 can include regulated performance parameters 570 for electrical energy that is provided at regulated high-side interface 131 by the set of battery modules 556 that are connected to battery circuit 129, which can include a regulated voltage 572, a regulated current 574, a regulated power 576, and/or other suitable regulated performance parameters.

Data 518 can identify disconnected battery modules 580 of battery group 110 that do not form part of the set of battery modules 556. Disconnected battery modules 580 can be identified by respective battery module identifiers 582.

Data 518 can include duty cycle data 590, including data that defines a high-side duty cycle 592 at which high-side driver 134 is to be operated, and a low-side duty cycle 594 at which low-side driver 136 is to be operated by buck regulator 132.

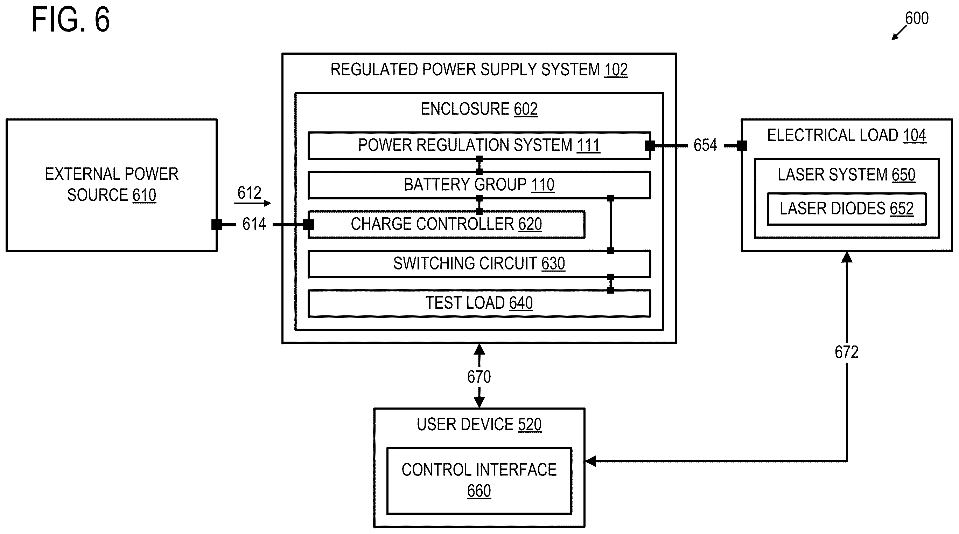

FIG. 6 is a schematic diagram depicting an integrated system 600 for providing regulated electrical power to an electrical load. Integrated system 600 is an example of electrical system 100 of FIG. 1. For example, integrated system 600 includes regulated power supply system 102 and electrical load 104 of FIG. 1. Additionally, system 600 includes an external power source 610 that can supply electrical energy 612 to regulated power supply system 102 to charge battery group 110. As an example, external power source 610 can supply electrical energy 612 to regulated power supply system 102 over a multi-conductor power supply cable 614 or other suitable electrical pathway.

Regulated power supply system 102 can include a charge controller 620 that controls charging of battery group 110 with electrical energy 612 supplied by external power source 610. In FIG. 6, charge controller 620 is schematically depicted electrically coupled to battery group 110. As an example, charge controller 620 can supply electrical energy received from external power source 610 to battery group 110 via high-side electrical interconnect 124 and low-side electrical interconnect 126 of FIG. 1. Charge controller 620 can process electrical energy 612 to a form suitable for battery group 110, including filtering, converting from AC to DC, and/or regulating the voltage supplied to the battery group.

Regulated power supply system 102 can further include a switching circuit 630 and a test load 640. In FIG. 6, switching circuit 630 is schematically depicted electrically coupled to battery group 110 and to test load 640. As an example, switching circuit 630 can connect high-side electrical interconnect 124 and low-side electrical interconnect 126 of battery group 110 to test load 640 to measure operating conditions (e.g., 540 of FIG. 5), including module-specific voltage 546, module-specific current 548, and module-specific charge state 552. Alternatively, a respective instance of test load 640 can be integrated with and form part of each module interface circuit 120 of FIGS. 1 and 2 to enable measurement of operating conditions. An example method for measuring operating conditions of the battery modules of battery group 110 is described in further detail with reference to FIG. 6.

In at least some examples, components of regulated power supply system 102 can be housed within and/or mounted to an enclosure 602. For example, power regulation system 111, battery group 110, charge controller 620, switching circuit 630, and test load 640 can be housed within and/or mounted to enclosure 602. As another example, battery modules 112 of battery group 110 can be located apart from enclosure 602. In this example, module interface circuits 120 can be housed within and/or mounted to enclosure 602, or the module interface circuits can be mounted to their respective battery modules of battery group 110 and located apart from enclosure 602.

In the example of FIG. 6, electrical load 104 includes or takes the form of a high voltage laser system that includes a plurality of laser diodes 652. It will be understood that laser system 650 is provided as an example of electrical load 104, and that other suitable electrical loads can be used. In FIG. 6, electrical load 104, including laser system 650 is electrically coupled to power regulation system 111 via one or more electrical pathways 654. As an example, the one or more electrical pathways 654 can include or be electrically coupled to regulated high-side interface 131. Electrical pathways 654 can further electrically couple ground reference 128 between electrical load 104 and power regulation system 111. Electrical pathways 654 can take the form of a multi-conductor power supply cable, as an example.

In some examples, the plurality of laser diodes 652 can be configured to operate at a specific voltage, which can be provided by power regulation system 111 as a regulated voltage supplied via regulated high-side interface 131 of FIG. 1. Furthermore, in some examples, laser system 650 can be operated at a variety of target voltages - e.g., depending on the quantity and/or type of laser diodes 652 that are to be operated in a given case. For example, laser system 650 may be selectively operated at two or more voltages by engaging or disengaging one or more of laser diodes 652.

System 600 further includes user device 520, previously described with reference to FIG. 5. User device 520 can include a control interface 660 that can be operated by a user to control operation of regulated power supply system 102 and/or electrical load 104 (including laser system 650). In FIG. 6, user device 520 is communicatively coupled to regulated power supply system 102 at 670 to control operation of regulated power supply system 102. Additionally, user device 520 is communicatively coupled to electrical load 104 at 672, including laser system 650 to control operation of the laser system. As the target operational voltage of laser system 650 can be varied, for example, by a user via control interface 660, the regulated voltage supplied by regulated power supply system 102 to laser system 650 can be varied to achieve the target operational voltage. For example, regulated power supply system 102 can obtain target performance parameters at operation 412 of FIG. 4 from user device 520.

FIG. 7 is a flow diagram depicting an example method 700 for performing a test process 702 that includes measuring operating conditions of individual battery modules of a battery group that includes a plurality of battery modules. Battery group 110 of FIG. 1 is an example of a battery group that can be measured by performing method 700. As an example, method 700 can be performed by control system 160 of FIG. 1, and more specifically by computing system 500 of FIG. 5 via a respective module interface circuit 120 that is electrically coupled to anode and cathode terminals of each battery module of the battery group.

At 710, the method includes receiving a control input to initiate and perform test process 702 with respect to the battery group. As an example, a user can provide a control input via a user interface that is received by control system 160 of FIG. 1. The test process can be initiated and performed by the control system responsive to the control input.

At 712, the method includes performing test process 702 with respect to the battery group. As previously described, the test process 702 can be performed at or by control system 110 of FIG. 1, and more specifically by computing system 500 of FIG. 5. In some examples, test process 702 is performed responsive to the control input received at 710.

As part of test process 702, at 714, the method includes independently disconnecting each battery module of the plurality of battery modules of the battery group from a connected state to a disconnected state with respect to a test load via a switching circuit (e.g., 250 of FIG. 2) of the module interface circuit (e.g., 120 of FIGS. 1 and 2) that is electrically coupled to the cathode and anode terminals of that battery module. The test load in this example can refer to test load 640 of FIG. 6.

As part of test process 702, at 716, the method includes performing module-specific testing of the plurality of battery modules of the battery group. As part of module-specific testing performed at 716, each battery module of the plurality of battery modules of the battery group can be independently connected with respect to the test load for testing while the remaining battery modules of the battery group are in the disconnected state. A battery module for which module-specific testing is performed at operation 716 can be referred to as a subject battery module. As subsequently described, operations 718-726 can be performed for each subject battery module of the plurality of battery modules of the battery group as part of module-specific testing performed at 716.

As part of module-specific testing at 716, the method at 718 includes, for each battery module of the plurality of battery modules of the battery group, independently connecting that battery module from the disconnected state to the connected state with respect to the test load via the switching circuit (e.g., 250 of FIG. 2) of the module interface circuit that is electrically coupled to the cathode and anode terminals of that battery module while remaining battery modules of the battery group are in the disconnected state. For example, the control system can command the switching circuit of the module interface of the subject battery module to connect the battery module to the test load, which can refer to test load 640 of FIG. 6, as an example. The battery module that is connected at 718 while the remaining batteries are in the disconnected state can be referred to as the subject battery module.

At 720, the method includes, for each battery module of the plurality of battery modules of the battery group, independently measuring the one or more module-specific operating conditions of that battery module in the connected state via a measurement circuit (e.g., 240 of FIG. 2) of the module interface circuit that is electrically coupled to the cathode and anode terminals of that battery module to obtain one or more module-specific measurements while the remaining battery modules are in the disconnected state. For example, the control system can obtain one or more module-specific measurements of each module-specific operating condition for the subject battery module via the measurement circuit.

Module-specific measurements that are obtained for a subject battery module that is in the connected state with respect to the test load can include a module-specific voltage 546 of FIG. 5, a module-specific current 548 of FIG. 5, a module-specific power 550 of FIG. 5, and/or a module-specific charge state 552 of FIG. 5. In at least some examples, the one or more module-specific measurements obtained at 720 for each battery module in the connected state can include a plurality of measurements obtained for the module-specific operating condition(s) over a period of time.

As part of operation 720, the method at 722 can include outputting and/or storing the module-specific measurements obtained for the subject battery module. As an example, the module-specific measurements can be stored as part of measured operating conditions 540 of FIG. 5 within data 518 of storage machine 512. As another example, the module-specific measurements can be output to user device 520 via control interface 660.

At 724, the method includes disconnecting the subject battery module from the connected state to the disconnected state with respect to the test load. For example, the control system can disconnect the subject battery module via the switching circuit of the module interface circuit electrically coupled to the subject battery module.

As depicted schematically at 728, module specific-testing can be performed for each battery module of the plurality of battery modules by repeating operations 718 - 724 for each other battery module of the battery group as the subject battery module.

Further, the disclosure comprises configurations according to the following examples.

Example 1. A regulated power supply system, comprising: a battery group that includes a plurality of battery modules that collectively provide an unregulated voltage, via a battery circuit, to an unregulated high-side interface relative to a ground reference; and a power regulation system that includes: a regulated high-side interface configured to provide a regulated voltage to an electrical load relative to the ground reference; a plurality of module interface circuits in which, for each battery module of the battery group, a corresponding module interface circuit of the plurality of module interface circuits includes: a measurement circuit operable to measure a module-specific voltage of the battery module, and a switching circuit operable to switch the battery module between a connected state with respect to the battery circuit and a disconnected state with respect to the battery circuit; an inductor electrically coupled between the regulated high-side interface and the unregulated high-side interface; a capacitor electrically coupled between the regulated high-side interface and an anode electrical interconnect of a module interface circuit of the plurality of module interface circuits that interconnects an anode terminal of a battery module of the plurality of battery modules to the battery circuit; and a buck regulator configured to command a high-side driver to pass electrical energy to the inductor via the unregulated high-side interface during an on phase of a duty cycle during which the inductor is charged, and discontinue passing the electrical energy to the inductor during an off phase of the duty cycle to obtain a target voltage at the regulated high-side interface.

Example 2. The regulated power supply system of Example 1, further comprising a control system; wherein the control system is configured to command the buck regulator to the target voltage.

Example 3. The regulated power supply system of Example 2, wherein the control system is configured to obtain the target voltage via a control interface; and wherein the target voltage is user configurable via the control interface.

Example 4. The regulated power supply system of any of Examples 1-3, wherein the power regulation system further includes the high-side driver and a low-side driver; wherein the buck regulator is configured to command the low-side driver to pass electrical energy recycled from the inductor back to the battery group via the battery circuit during the off phase of the duty cycle of the high-side driver.

Example 5. The regulated power supply system of any of Examples 1-4, wherein each module interface circuit of the plurality of module interface circuits includes: a module-side cathode interface electrically coupled to a cathode terminal of the battery module, a module-side anode interface electrically coupled to an anode terminal of the battery module, a load-side cathode interface electrically coupled to the battery circuit, and a load-side anode interface electrically coupled to the battery circuit.

Example 6. The regulated power supply system of Example 5, wherein the switching circuit is operable to: connect the module-side cathode interface to the load-side cathode interface in the connected state, and disconnect the module-side cathode interface from the load-side cathode interface in the disconnected state.

Example 7. The regulated power supply system of Example 5, wherein the measurement circuit is operable to measure the module-specific voltage of the battery module between or across the module-side cathode interface and the module-side anode interface.

Example 8. The regulated power supply system of any of Examples 1-7, wherein the buck regulator is electrically coupled to the regulated high-side interface via an electrical connection that serves as a regulated high-side feedback path to the buck regulator for use in regulating voltage of unregulated high-side interface to the target voltage at the regulated high-side interface.

Example 9. A method of providing regulated electrical power to an electrical load from a battery group that includes a plurality of battery modules, the method comprising: measuring a module-specific voltage of each battery module of the battery group; obtaining a target voltage for a regulated-high side interface connected to the electrical load; selecting a set of battery modules of the battery group for connection to an unregulated high-side interface via a battery circuit based on the target voltage and the module-specific voltage measured for each battery module of the battery group; configuring the set of battery modules in a connected state with respect to the unregulated high-side interface via the battery circuit, and other battery modules of the battery group not in the set of battery modules in a disconnected state with respect to the unregulated high-side interface via the battery circuit; and regulating an unregulated voltage provided by the set of battery modules to the unregulated high-side interface to the target voltage at the regulated high-side interface via a buck regulator.

Example 10. The method of Example 9, wherein the buck regulator is configured to command a high-side driver to: pass electrical energy to an inductor that is electrically coupled between the unregulated high-side interface and the regulated high-side interface during an on phase of a duty cycle during which the inductor is charged, and discontinue passing the electrical energy to the inductor during an off phase of the duty cycle to obtain the target voltage at the regulated high-side interface.

Example 11. The method of Example 10, wherein the buck regulator is further configured to command a low-side driver to pass electrical energy recycled from the inductor back to the battery group via the battery circuit during the off phase of the duty cycle of the high-side driver.

Example 12. The method of any of Examples 9-11, wherein the target voltage is user configurable and is obtained via a control interface.

Example 13. The method of any of Examples 9-11, wherein for each battery module of the battery group, a corresponding module interface circuit includes a measurement circuit operable to measure the module-specific voltage of the battery module.

Example 14. The method of Example 13, wherein for each battery module of the battery group, a corresponding module interface circuit includes a switching circuit operable to configure the battery module in the connected state or the disconnected state.

Example 15. The method of Example 14, wherein each module interface circuit includes: a module-side cathode interface electrically coupled to a cathode terminal of the battery module, a module-side anode interface electrically coupled to an anode terminal of the battery module, a load-side cathode interface electrically coupled to the battery circuit, and a load-side anode interface electrically coupled to the battery circuit.

Example 16. The method of Example 15, wherein the switching circuit of each module interface circuit is operable to: connect the module-side cathode interface to the load-side cathode interface in the connected state, and disconnect the module-side cathode interface from the load-side cathode interface in the disconnected state.

Example 17. The method of any of Examples 15-16, wherein the measurement circuit of each module interface circuit is operable to: measure the module-specific voltage of the battery module between or across the module-side cathode interface and the module-side anode interface.

Example 18. The method of any of Examples 9-17, wherein the buck regulator is electrically coupled to the regulated high-side interface via an electrical connection that serves as a regulated high-side feedback path to the buck regulator for use in regulating voltage of unregulated high-side interface to the target voltage at the regulated high-side interface.

Example 19. An integrated system for providing regulated electrical power to an electrical load from a battery group that includes a plurality of battery modules, the system comprising: the electrical load; and a power regulation system that includes: a regulated high-side interface configured to provide a regulated voltage to the electrical load relative to a ground reference; a plurality of module interface circuits in which, for each battery module of the battery group, a corresponding module interface circuit of the plurality of module interface circuits includes: a measurement circuit operable to measure a module-specific voltage of the battery module, and a switching circuit operable to switch the battery module between a connected state with respect to the battery circuit and a disconnected state with respect to the battery circuit;
an inductor electrically coupled between the regulated high-side interface and the unregulated high-side interface; a capacitor electrically coupled between the regulated high-side interface and an anode electrical interconnect of a module interface circuit of the plurality of module interface circuits that interconnects an anode terminal of a battery module of the plurality of battery modules to the battery circuit; and a buck regulator configured to command a high-side driver to pass electrical energy to the inductor via the unregulated high-side interface during an on phase of a duty cycle during which the inductor is charged, and discontinue passing the electrical energy to the inductor during an off phase of the duty cycle to obtain a target voltage at the regulated high-side interface.

Example 20. The system of Example 19, wherein the electrical load includes or takes the form of a laser system that includes a plurality of laser diodes.

It will be understood that the configurations and/or approaches described herein are exemplary in nature, and that these specific embodiments or examples are not to be considered in a limiting sense, because numerous variations are possible. The specific routines or methods described herein may represent one or more of any number of processing strategies. As such, various acts illustrated and/or described may be performed in the sequence illustrated and/or described, in other sequences, in parallel, or omitted. Likewise, the order of the above-described processes may be changed.

The subject matter of the present disclosure includes all novel and non-obvious combinations and sub-combinations of the various processes, systems and configurations, and other features, functions, acts, and/or properties disclosed herein, as well as any and all equivalents thereof.

## Claims

1. A regulated power supply system, comprising:
a battery group that includes a plurality of battery modules that collectively provide an unregulated voltage, via a battery circuit, to an unregulated high-side interface relative to a ground reference; and
a power regulation system that includes:
a regulated high-side interface configured to provide a regulated voltage to an electrical load relative to the ground reference;
a plurality of module interface circuits in which, for each battery module of the battery group, a corresponding module interface circuit of the plurality of module interface circuits includes:
a measurement circuit operable to measure a module-specific voltage of the battery module, and
a switching circuit operable to switch the battery module between a connected state with respect to the battery circuit and a disconnected state with respect to the battery circuit;
an inductor electrically coupled between the regulated high-side interface and the unregulated high-side interface;
a capacitor electrically coupled between the regulated high-side interface and an anode electrical interconnect of a module interface circuit of the plurality of module interface circuits that interconnects an anode terminal of a battery module of the plurality of battery modules to the battery circuit; and
a buck regulator configured to command a high-side driver to pass electrical energy to the inductor via the unregulated high-side interface during an on phase of a duty cycle during which the inductor is charged, and discontinue passing the electrical energy to the inductor during an off phase of the duty cycle to obtain a target voltage at the regulated high-side interface.

2. The regulated power supply system of claim 1, further comprising a control system;
wherein the control system is configured to command the buck regulator to the target voltage;
optionally wherein the control system is configured to obtain the target voltage via a control interface; and
optionally wherein the target voltage is user configurable via the control interface.

3. The regulated power supply system of claim 1 or claim 2, wherein the power regulation system further includes the high-side driver and a low-side driver;
wherein the buck regulator is configured to command the low-side driver to pass electrical energy recycled from the inductor back to the battery group via the battery circuit during the off phase of the duty cycle of the high-side driver.

4. The regulated power supply system of any preceding claim, wherein each module interface circuit of the plurality of module interface circuits includes:
a module-side cathode interface electrically coupled to a cathode terminal of the battery module,
a module-side anode interface electrically coupled to an anode terminal of the battery module,
a load-side cathode interface electrically coupled to the battery circuit, and
a load-side anode interface electrically coupled to the battery circuit.

5. The regulated power supply system of claim 4, wherein the switching circuit is operable to:
connect the module-side cathode interface to the load-side cathode interface in the connected state, and
disconnect the module-side cathode interface from the load-side cathode interface in the disconnected state;
and/or wherein the measurement circuit is operable to measure the module-specific voltage of the battery module between or across the module-side cathode interface and the module-side anode interface.

6. The regulated power supply system of any preceding claim, wherein the buck regulator is electrically coupled to the regulated high-side interface via an electrical connection that serves as a regulated high-side feedback path to the buck regulator for use in regulating voltage of unregulated high-side interface to the target voltage at the regulated high-side interface.

7. A method of providing regulated electrical power to an electrical load from a battery group that includes a plurality of battery modules, the method comprising:
measuring a module-specific voltage of each battery module of the battery group;
obtaining a target voltage for a regulated-high side interface connected to the electrical load;
selecting a set of battery modules of the battery group for connection to an unregulated high-side interface via a battery circuit based on the target voltage and the module-specific voltage measured for each battery module of the battery group;
configuring the set of battery modules in a connected state with respect to the unregulated high-side interface via the battery circuit, and other battery modules of the battery group not in the set of battery modules in a disconnected state with respect to the unregulated high-side interface via the battery circuit; and
regulating an unregulated voltage provided by the set of battery modules to the unregulated high-side interface to the target voltage at the regulated high-side interface via a buck regulator.

8. The method of claim 7, wherein the buck regulator is configured to command a high-side driver to:
pass electrical energy to an inductor that is electrically coupled between the unregulated high-side interface and the regulated high-side interface during an on phase of a duty cycle during which the inductor is charged, and
discontinue passing the electrical energy to the inductor during an off phase of the duty cycle to obtain the target voltage at the regulated high-side interface;
optionally wherein the buck regulator is further configured to command a low-side driver to pass electrical energy recycled from the inductor back to the battery group via the battery circuit during the off phase of the duty cycle of the high-side driver.

9. The method of claim 7 or claim 8, wherein the target voltage is user configurable and is obtained via a control interface.

10. The method according to any of claims 7 to 9, wherein for each battery module of the battery group, a corresponding module interface circuit includes a measurement circuit operable to measure the module-specific voltage of the battery module;
optionally wherein for each battery module of the battery group, a corresponding module interface circuit includes a switching circuit operable to configure the battery module in the connected state or the disconnected state.

11. The method of claim 10, wherein each module interface circuit includes:
a module-side cathode interface electrically coupled to a cathode terminal of the battery module,
a module-side anode interface electrically coupled to an anode terminal of the battery module,
a load-side cathode interface electrically coupled to the battery circuit, and
a load-side anode interface electrically coupled to the battery circuit.

12. The method of claim 11, wherein the switching circuit of each module interface circuit is operable to:
connect the module-side cathode interface to the load-side cathode interface in the connected state, and
disconnect the module-side cathode interface from the load-side cathode interface in the disconnected state;
and/or wherein the measurement circuit of each module interface circuit is operable to: measure the module-specific voltage of the battery module between or across the module-side cathode interface and the module-side anode interface.

13. The method according to any of claims 7 to 12, wherein the buck regulator is electrically coupled to the regulated high-side interface via an electrical connection that serves as a regulated high-side feedback path to the buck regulator for use in regulating voltage of unregulated high-side interface to the target voltage at the regulated high-side interface.

14. An integrated system for providing regulated electrical power to an electrical load from a battery group that includes a plurality of battery modules, the system comprising:
the electrical load; and
a regulated power supply system according to any of claims 1 to 8, wherein the regulated high-side interface is configured to provide the regulated voltage to the electrical load relative to the ground reference.

15. The system of claim 14, wherein the electrical load includes or takes the form of a laser system that includes a plurality of laser diodes.
